# EUROPEAN PATENT APPLICATION

(11) **EP 2 677 551 A1**
(43) Date of publication of application: **25.12.2013**
(21) Application number: 12172987.5
(22) Date of filing: 21.06.2012
(51) Int. Cl.: H01L 31/048, H01L 31/0216, H01L 31/0236, H01L 31/18

(54) **Method for manufacturing a photovoltaic device using laser irradiation.**

(71) Applicant: Excico Group, 3500 Hasselt (BE)
(72) Inventor: Emeraud, Thierry, 3500 Hasselt (BE); Lerat, Jean-François, 3500 Hasselt (BE)
(74) Representative: BiiP cvba

(57) **Abstract**

The present invention relates to a method for manufacturing a photovoltaic device comprising:
a. manufacturing a photovoltaic layer stack,
b. providing an encapsulation layer on the surface region of the photovoltaic layer stack before laser irradiation,
c. selecting a set of laser irradiation parameters,
d. simultaneously irradiating the encapsulation layer and the photovoltaic layer stack using said set of laser irradiation parameters,

characterized in that the encapsulation layer is non-sacrificial

## Description

### FIELD OF THE INVENTION

The present invention relates to a method for manufacturing a photovoltaic device using laser irradiation.

### BACKGROUND OF THE INVENTION

In photovoltaic cell manufacturing, thermal annealing of crystalline silicon, amorphous silicon, polysilicon, etc. is commonly used for obtaining re-crystallization, dopant activation, defect repair, etc.

In state-of-the-art photovoltaic device manufacturing, thermal annealing is increasingly performed by laser irradiation. By enabling a very fast heat treatment and shallow depth of the heated region, this technique offers significant advantages over standard longer duration Rapid Thermal Processing (RTP) or furnace processes where heat diffusion to a non-desired depth or damage in a photovoltaic layer stack is not always easy to avoid.

However, in order to maintain the dimensional stability, surface texture and planarity of the irradiated regions, an encapsulation layer (often also called capping layer) is deposited on top of the photovoltaic layer stack before laser irradiation. An example is given in US4751193, wherein a protective silicon nitride layer is provided over the amorphous or polysilicon layer to maintain the shape of the layer after it is melted, and during recrystallization.

A general disadvantage of the above method is that such encapsulation layer is sacrificial: its sole purpose is to protect the photovoltaic layer stack during laser irradiation and to influence the temperature gradient across the stack, whereupon it is removed again, resulting in additional process steps, waste of material, and higher photovoltaic device cost.

Considering the above drawbacks, it is a first object of the present invention to provide a method for manufacturing a photovoltaic device wherein it is not required for obtaining satisfying thermal annealing results to introduce additional process steps in the thermal annealing step.

Another object of the present invention is to provide a method wherein a photovoltaic layer stack can be exposed to a desired in-depth temperature profile without making use of an additional sacrificial layer.

It is a second object of the present invention to provide a method for manufacturing a photovoltaic device enabling the photovoltaic layer stack to be exposed to specific laser irradiation conditions to control the level of the defect annealing, material recrystallization, material alloying or dopant activation at those different depths.

As another object, the present invention provides a method having the ability to engineer the electrical properties of photovoltaic layer stack and to achieve either a controlled in-depth gradient of electrical properties across one or more layers of the layer stack.

Still another object of the present invention is to provide a method which can be applied by means of standard laser annealing equipment optimizing global manufacturing cost in the PV line and therefore photovoltaic device production cost on a $/Watt peak basis.

Another object of the present invention is to provide photovoltaic devices with improved efficiency.

The present invention meets the above objects by providing a method for manufacturing a photovoltaic device wherein laser irradiation is used and wherein the laser irradiation parameters are selected such that non-sacrificial layers, i.e. layers present in the final photovoltaic device, can be used as encapsulation layers.

### SUMMARY OF THE INVENTION

The present invention is directed to a method for manufacturing a photovoltaic device comprising:
a. manufacturing a photovoltaic layer stack,
b. providing an encapsulation layer on the surface region of the photovoltaic layer stack before laser irradiation,
c. selecting a set of laser irradiation parameters,
d. simultaneously irradiating the encapsulation layer and the photovoltaic layer stack using said set of laser irradiation parameters,
characterized in that the encapsulation layer is a non-sacrificial layer.

### DETAILED DESCRIPTION

In the context of the present invention, a photovoltaic layer stack is understood as any kind of stack built-up by at least 2 different layers of which one optionally is a substrate, so the photovoltaic layer stack can be one or a plurality of layers on a substrate.

In the context of the present invention, an encapsulation layer is a material layer on top of a layer to be laser irradiated, provided to improve the effect or the result of the laser irradiation on the underlying layer compared to irradiation without encapsulation layer.

According to a first embodiment of the present invention, a method for manufacturing a photovoltaic device is provided comprising:
a. manufacturing a photovoltaic layer stack,
b. providing an encapsulation layer on the surface region of the photovoltaic layer stack before laser irradiation,
c. selecting a set of laser irradiation parameters,
d. simultaneously irradiating the encapsulation layer and the photovoltaic layer stack using said set of laser irradiation parameters,
characterized in that the encapsulation layer is a non-sacrificial layer.

By selecting appropriate laser irradiation parameters and providing an appropriate encapsulation layer, the encapsulation layer may be a non-sacrificial layer, which in the context of the present invention is a layer maintained in the final photovoltaic device, fully, partially or patterned, unmodified or modified (partially or completely) upon laser irradiation, and which is beneficial to the final photovoltaic device performance. Or in other words, by selecting appropriate laser irradiation parameters, a layer maintained in the final photovoltaic device as a full, partial or patterned layer, which can be unmodified or modified (partially or completely) upon laser irradiation and which is beneficial to the final photovoltaic device performance, may be used as encapsulation layer to improve the effect or the result of laser irradiation on the underlying layer.

A general advantage thereof is that it is not required for obtaining satisfying thermal annealing results to introduce additional process steps to the thermal annealing step in photovoltaic device manufacturing, resulting in lower photovoltaic device cost.

Another advantage is that a photovoltaic layer stack can be exposed to a desired in-depth temperature profile without making use of an additional sacrificial layer.

In order to select an appropriate set of laser irradiation parameters a target in-depth temperature profile to be obtained across the photovoltaic layer stack may be determined. Beam energy density and/or pulse length, and even wavelength, may be selected as a function of target in-depth temperature profile to be obtained over the photovoltaic layer stack.

The target in-depth temperature profile to be obtained across the photovoltaic layer stack may be determined based on desired material properties to be obtained in the stack, such as crystallinity, dopant activation, or metal alloying with a given thickness, stoichiometry (or composition) and crystalline phase (or crystalline orientation)..

Selecting an appropriate set of laser irradiation parameters may further comprise taking in account the absorbance and/or reflectivity of the non-sacrificial encapsulation layer and/or the photovoltaic layer stack.

Additionally, in selecting the set of laser irradiation parameters and taking into consideration a given layer stack structure, the in-depth irradiation energy propagation and/or the penetration depth of the laser irradiation in the photovoltaic layer stack may be predicted.

In an embodiment in accordance with the present invention, the non-sacrificial encapsulation layer may be at least partially anti-reflective to the laser irradiation compared to the surface region of the photovoltaic layer stack, or may be more at least partially reflective to the laser irradiation compared to the surface region of the photovoltaic layer stack. Reflectivity of the non-sacrificial encapsulation layer will influence the in-depth temperature gradient to which the photovoltaic layer stack is exposed.

In another embodiment, the non-sacrificial encapsulation layer may be thermally insulating the photovoltaic layer stack during laser irradiation, for example in cases where the thermal losses are minimized thanks to a lower thermal budget obtained in the photovoltaic laser stack capped with the encapsulation layer leading to higher equipment throughput for the same laser energy.

In still another embodiment, the encapsulation layer may be a patterned layer combined or not with patterned underlying layers present in the photovoltaic layer stack, resulting in locally different in-depth temperature profiles in order to achieve locally different material properties upon exposure to the same laser energy.

In still another embodiment, the non-sacrificial encapsulation layer may prevent contamination of the surface region of the photovoltaic layer stack. More specifically, the non-sacrificial layer may be a chemical barrier against contamination present in ambient atmosphere during thermal annealing.

In still another embodiment, the non-sacrificial encapsulation layer may prevent out-diffusion from the photovoltaic layer stack. More specifically, the non-sacrificial layer may be a chemical barrier against out-diffusion of certain chemical components such as volatile components present in the layer stack during laser irradiation, preserving material integrity and photovoltaic device performance

The non-sacrificial encapsulation layer may comprise any material suitable for use in photovoltaic devices and suitable for encapsulating a photovoltaic layer during laser irradiation. Preferably, the encapsulation layer may be a metal layer, a metal oxide layer, a metal sulfide layer, a dielectric layer, a doped or undoped semiconductor layer or a combination thereof.

The non-sacrificial encapsulation layer may have any function in a final photovoltaic device, for example anti-reflective coating (ARC), passivation layer, transparent conductive oxide (TCO), p-type or n-type semiconductor junction layer, contact or part of a contact, or a combination thereof.

In an embodiment in accordance with the present invention, a method is provided comprising modifying the interface between the encapsulation layer and the surface region of the photovoltaic layer stack underneath. For example, in case the encapsulation layer is a metal and the surface region of the photovoltaic layer stack is silicon, metal silicide may be formed at the interface.

In other embodiments the encapsulation layer and the photovoltaic layer stack (one or a plurality of layers thereof) may be simultaneously modified in depth.

In order to influence the in-depth temperature gradient over the photovoltaic layer stack, the thickness of the non-sacrificial encapsulation layer may be adjusted as a function of desired in-depth temperature gradient.

In the context of the present invention, the laser source may be any laser source whose wavelength, energy and pulse duration is adapted to the process, such as solid state lasers, diode lasers, or excimer lasers. Preferably, the laser source may be an excimer layer, more preferably a xenon chloride excimer laser.

The wavelength of the laser source may be in the range of 100 nm to 900 nm, 190 nm to 600 nm, 190 nm to 550 nm, or preferably 190 nm to 480 nm due to the high energy absorption of silicon at those wavelengths.

The irradiation energy may be in the range of 1 Joules to 25 Joules. In order to achieve these energies, the laser discharge volume is optimized to typically 10 cm (inter electrodes spacing) x 7 to 10 cm (discharge width) x 100 to 200 cm (discharge length).

In an embodiment of the present invention, the laser source may be adapted to produce a irradiation beam with an beam energy density between 0,01 and 10 J/cm², preferably between 0.01 and 5 J/cm², most preferably between 0.01 to 1 Joules/cm². The laser energy density may be adapted to match the desired temperature gradient in the photovoltaic layer stack.

In a preferred embodiment, the laser may be an excimer laser adapted to produce a large area output beam of more than 60 cm², more than 80 cm², preferably 100 cm², having a projected beam spot typically of at least 1 cm², at least 5 cm², and up to 100 cm² with an energy density between 0,01 and 10 J/cm².

In a particular embodiment in accordance with the present invention, with each pulse a portion of at least 1 cm², at least 5 cm², at least 10 cm², or at least 100 cm² may be irradiated, which makes the present invention suitable for industrial manufacturing of photovoltaic cells at high throughputs.

Alternatively, the laser irradiation may comprise scanning the non-sacrificial encapsulation layer with a line beam having a line length equal to or (slightly) exceeding one dimension of the substrates used or of the final photovoltaic device area, which makes the present invention suitable for industrial manufacturing of in particular thin film photovoltaic cells at high throughputs. For example, by having a large substrate continuously flowing in a direction perpendicular to the line beam at a scanning speed (several mm/sec), consecutive pulsed laser shots will enable continuous anneal of the whole area.

The irradiation beam may be continuous or pulsed, preferably having a pulse duration in the range of 100 ns to 1000 ns, or between 100 ns and 300 ns, or preferably between 100 and 200 nanoseconds.

In a preferred embodiment of the present invention, the laser source may be an excimer laser having a wavelength of 308 nm, a pulse duration between 100 and 200 nanoseconds and a projected irradiation beam energy density between 0.01 and 1 J/cm²_{.}

The photovoltaic layer stack, may comprise any material suitable for photovoltaic applications such as, but not limited to crystalline silicon, undoped silicon or doped silicon, polycrystalline silicon, implanted silicon, amorphous silicon, silicon germanium, III-V compound semiconductors such as gallium arsenide, gallium aluminum arsenide, gallium nitride and the like, copper indium diselenide (CulnSe₂) or copper indium gallium diselenide (Cu(ln,Ga)Se₂), CZTS (Cu₂ZnSnS₄), and the like, cadmium telluride (CdTe) and the like, or layers found in any organic photovoltaic device or dye- sensitized solar cell device

### EXAMPLE 1: Manufacturing of a homo-junction crystalline Silicon solar cell:

| Before laser irradiation: | | After laser irradiation: |
|---|---|---|
| 0 - Ambient atmosphere | | 0 - Ambient atmosphere |
| 1 - thin metal encapsulation layer (20nm to 100nm) such as Ni or Ti | | 1 - NiₓSi_{y} (resp TiₓSi_{y}) as a result of metal silicidation induced by laser at the interface with underlying doped silicon. |
| 2- underlying doped Silicon material | | 2 - Modified underlying Si material (higher doping level due to laser annealing) |
| 3- Silicon Substrate (with different doping level or nature than layer 2) | | 3- unmodified silicon Substrate as in starting structure |

A thin metal non-sacrificial encapsulation layer and laser irradiation is used to enable the realization of an improved metal contacting scheme through the creation of a metal silicide layer on sufficiently active silicon. The resulting photovoltaic device shows improved performance: +0.6% absolute efficiency using laser anneal @ 0.55J/cm² vs. Rapid Thermal Anneal (RTA).

### EXAMPLE 2: Manufacturing of a homo-junction crystalline Silicon solar cell with backside passivation

| Before laser irradiation: | | After laser irradiation: |
|---|---|---|
| 0 - Ambient atmosphere | | 0 - Ambient atmosphere |
| 1 - thin Al2O3 encapsulation layer (20nm to 70nm) | | 1 - unmodified thin Al2O3 encapsulation layer (20nm to 70nm) |
| 2- underlying doped Silicon material | | 2 - Modified underlying Si material (higher doping level & lower defects) |
| 3- Silicon Substrate (with different doping level or nature than layer 2) | | 3- unmodified silicon Substrate as in starting structure |

The silicon layer at the back side of PV device is recrystallized through an Al2O3 encapsulation layer (acting as an electrical passivation layer in the final PV device) in order to activate dopants in silicon and create some desired Back Surface Field Effect locally.

Using 5nm Al2O3 encapsulation layer, the underlying silicon starts to melt at 1.9 J/cm². Melting depth @2J/cm² is 0.17µm.

Using 30nm Al2O3 encapsulation layer, the underlying silicon starts to melt at 0.8J/cm². Melted depth @2J/cm² is 1.8µm.

Without any Al2O3 encapsulation layer, melted depth of c-Si @ 2J/cm² is calculated at 0.035µm.

Slightly larger melting times are observed for c-Si coated with 5nm Al2O3 vs. bare c-Si, but 3 times larger melting times are measured for c-Si coated with 30nm Al2O3.

### EXAMPLE 3: Manufacturing of a thin film copper indium gallium diselenide (CIGS) hetero-junction solar cell

| Before laser irradiation: | | After laser irradiation: |
|---|---|---|
| 0- Ambient atmosphere | | 0- Ambient atmosphere |
| 1- CdS or ZnS buffer layer | | 1- modified CdS or ZnS buffer layer |
| 2- CIGS absorbing layer (0.5-1.5µm thick) | | 2- modified CIGS absorbing layer (0.5-1.5µm thick) |
| 3- Glass or plastic or metal substrate | | 3- Glass or plastic or metal substrate |

A CIGS layer is annealed through a CdS encapsulation (buffer layer) layer or through a TCO/CdS stack in order to improve CdS/CIGS interface and PV device performance. The case is also applicable with improvement of the TCO/CdS interface. As a result, the interface between CdS encapsulation layer 1 and CIGS layer 2 was improved and the crystallinity of the CdS buffer was also improved. Moreover the CdS encapsulation layer acts as barrier layer against Se out-diffusion during laser annealing.

### EXAMPLE 4: Manufacturing of a silicon hetero-junction solar cell

| Before laser irradiation: | | After laser irradiation: |
|---|---|---|
| 0- Ambient atmosphere | | 0- Ambient atmosphere |
| 1- TCO | | 1- modified TCO |
| 2- amorphous silicon (a-Si) layer | | 2- modified amorphous (a-Si) silicon layer |
| 3- crystalline silicon bulk | | 3- crystalline silicon bulk |

An amorphous layer is annealed through a TCO layer and improves the TCO/a-Si interface by reducing contact resistance. Furthermore, the amorphous silicon may crystallize partially at the interface with TCO while keeping its amorphous properties at the interface with bulk silicon. As a result, the light absorption and electrical losses are reduced, contributing in a general improvement of the solar cell performances.

## Claims

1. A method for manufacturing a photovoltaic device comprising:
a. manufacturing a photovoltaic layer stack,
b. providing an encapsulation layer on the surface region of the photovoltaic layer stack before laser irradiation,
c. selecting a set of laser irradiation parameters,
d. simultaneously irradiating the encapsulation layer and the photovoltaic layer stack using said set of laser irradiation parameters,
**characterized in that** the encapsulation layer is a non-sacrificial layer.

2. A method according to claim 1, wherein a target in-depth temperature profile to be obtained over the photovoltaic layer stack is determined

3. A method according to claim 1 or 2, wherein the encapsulation layer is at least partially anti-reflective to the laser irradiation compared to the surface region of the photovoltaic layer stack.

4. A method according to claim 1 or 2, wherein the encapsulation layer is at least partially reflective to the laser irradiation compared to the surface region of the photovoltaic layer stack.

5. A method according to claims 1 to 4, wherein the encapsulation layer is thermally insulating the photovoltaic layer stack.

6. A method according to claims 1 to 5, wherein the encapsulation layer is a patterned layer combined or not with patterned underlying layers present in the photovoltaic layer stack.

7. A method according to claims 1 to 6, wherein the encapsulation layer comprises a metal layer, a metal oxide layer, a metal sulfide layer, a dielectric layer, a doped or undoped semiconductor layer or a combination thereof.

8. A method according to claims 1 to 7, wherein the encapsulation layer is an anti-reflective coating, a passivation layer, a transparent conductive oxide, p-type or n-type semiconductor junction layer, a contact or part of a contact, or a combination thereof.

9. A method according to claims 1 to 8, comprising modifying the interface of the encapsulation layer and the surface region of the photovoltaic layer stack.

10. A method according to claims 1 to 9, comprising simultaneously modifying the encapsulation layer and the photovoltaic layer stack.

11. A method according to any of the above claims, wherein the set of laser irradiation parameters is selected based on the in-depth irradiation energy propagation and/or the penetration depth in the photovoltaic layer stack.

12. A method according to any of the above claims, using an excimer laser irradiation source.
